Europäisches Patentamt

European Patent Office

Office européen des brevets

(19)

(11) **EP 0 928 057 B1**

(12) **FASCICULE DE BREVET EUROPEEN**

(45) Date de publication et mention
de la délivrance du brevet:
**24.09.2003 Bulletin 2003/39**

(51) Int Cl.⁷: **H02M 3/158**, H03K 17/0814,
H03K 17/10

(21) Numéro de dépôt: **98403161.7**

(22) Date de dépôt: **15.12.1998**

(54) **Interrupteur haute tension realisé à partir de cellules resonantes connectées en serie**

Hochspannungsschalter aus reihengeschalteten resonanten Zellen

High voltage switch comprising resonant cells connected in series

(84) Etats contractants désignés:
**CH DE GB IT LI**

(30) Priorité: **18.12.1997 FR 9716070**

(43) Date de publication de la demande:
**07.07.1999 Bulletin 1999/27**

(73) Titulaire: **COMMISSARIAT A L'ENERGIE
ATOMIQUE
75015 Paris (FR)**

(72) Inventeurs:
• **Chartroux, Daniel
26200 Montelimar (FR)**
• **Lapassat, Nicolas
26790 Suze-la-Rousse (FR)**
• **Rieux, Olivier
38100 Grenoble (FR)**

(74) Mandataire: **Poulin, Gérard et al
BREVALEX
3, rue du docteur Lancereaux
75008 Paris (FR)**

(56) Documents cités:
**EP-A- 0 353 406          FR-A- 2 279 250**

• **YU-MING CHANG ET AL: "DESIGN AND
ANALYSIS OF H-SOFT-SWITCHED
CONVERTERS" IEE PROCEEDINGS: ELECTRIC
POWER APPLICATIONS, vol. 142, no. 4, 1 juillet
1995, pages 255-261, XP000544143**

## Description

Domaine de l'invention

L'invention concerne un interrupteur électronique haute tension réalisé à partir d'une pluralité de cellules résonantes, connectées en série. Cet interrupteur haute tension est destiné à être utilisé, en particulier, dans des convertisseurs DC/DC haute tension (DC : courant continu).

Etat de la technique

Les convertisseurs DC/DC haute tension sont des systèmes alimentés par une tension continue et qui permettent de délivrer, en sortie, une haute tension continue, c'est-à-dire une tension supérieure à 1 kV. Ils peuvent être utilisés, par exemple, au sein d'une alimentation continue haute tension, c'est-à-dire dans un système destiné à transformer l'énergie électrique issue du réseau électrique national en une haute tension continue.

Les alimentations continues haute tension comportent, généralement un étage élévateur de tension. Cet étage élévateur de tension transforme la tension alternative du réseau électrique national en une autre tension alternative de même fréquence, mais d'amplitude supérieure. Une régulation de la haute tension doit donc être opérée, soit en amont, soit en aval, de l'étage élévateur.

On distingue deux types d'alimentations haute tension :

- les alimentations haute tension régulées sur la basse tension, c'est-à-dire les alimentations dans lesquelles la régulation de la haute tension s'opère en amont de l'étage élévateur ; et
- les alimentations haute tension régulées sur la haute tension, c'est-à-dire les alimentations dont la régulation de la haute tension s'opèrent en aval de l'étage élévateur.

Parmi les alimentations haute tension, certaines fonctionnent à la fréquence du réseau, soit 50 Hz en France. Ces alimentations comportent, par exemple, deux convertisseurs haute tension, qui utilisent la fréquence du réseau électrique. Ces deux convertisseurs, sont décrits dans les articles « The realization of the power converters for the CERN FR system of LEP », A. DELIZEE, J.-C. CARLIER, P. PROUDLOCK, IEEE Proceedings, 1990 Nineteenth Power Modulator Symposium et « Thigh voltage d. c. power supplies », J. S. BEKINK, A. J. J. COLIJN, Holec Projects, EPE Journal, June 1994. Les convertisseurs décrits dans ces articles comportent des transformateurs magnétiques qui permettent d'élever la tension alternative à la fréquence du réseau ; ils comportent également un redresseur, ainsi qu'un système de régulation à thyristors. La tension, ainsi régulée, est introduite dans un étage élévateur, puis dans un étage de redressement et un filtrage ; on obtient ainsi, en sortie du convertisseur, une haute tension continue. Ces convertisseurs sont généralement utilisés pour de très fortes puissances et permettent la réalisation d'une alimentation avoisinant les 1 MW.

D'autres types d'alimentations haute tension fonctionnent en haute fréquence, c'est-à-dire à une fréquence d'au moins 10 kHz. Pour obtenir cette haute fréquence, le courant provenant du réseau électrique est d'abord redressé et filtré, permettant ainsi d'obtenir une basse tension continue. Il est ensuite introduit dans un étage onduleur qui consiste à transformer la basse tension continue en une tension alternative, grâce à l'onduleur. Cette tension est ensuite introduit dans l'étage élévateur, puis dans un autre étage de redressement et de filtrage avant de devenir une haute tension continue.

La régulation de la tension, dans ce type d'alimentation, peut avoir lieu à différents niveaux. Tout d'abord, elle peut avoir lieu sur le redressement de la tension issue du réseau, au moyen d'un pont de GRAETZ, comme cela est décrit dans l'article « L'électronique de puissance dans l'imagerie médicale », J. LAEUFFER et J. SALESSES, Revue Général de l'Electricité, Juin 1992.

Elle peut aussi être effectuée au niveau de la tension continue issue de l'étage de redressement et de filtrage. Elle est alors réalisée au moyen d'un hacheur, comme cela est décrit dans l'article « High power high voltage generator », I. BONANNI, L. CRISTOFOLI, Proceedings of EPE 87 Grenoble.

Dans ces deux cas, il s'agit d'une régulation de la tension continue fournie en entrée de l'étage onduleur. Cette solution est généralement utilisée lorsque l'onduleur utilisé est de type pleine onde et qu'il ne contrôle pas l'amplitude de sa tension alternative de sortie.

Toutefois, dans certains cas, en plus de la fréquence, l'amplitude de la tension alternative fournie en entrée de l'étage élévateur est réglée au niveau de l'étage onduleur. Cette opération est réalisée au moyen, par exemple, d'un onduleur résonant, tel que décrit dans le document « L'électronique de puissance dans l'imagerie médicale », J. LAEUFFER et J. SALESSES, Revue Générale de l'Electricité, Juin 1992 ou dans l'article « Les composants à grille isolée en mode thyristordual », H. FOCH, M. METZ, J. P. ARCHES, C. SAUBION, Revue Générale de l'Electricité, Février 1994 ou encore dans l'ouvrage intitulé « La commutation douce dans la conversion statique de l'énergie électrique », Y. CHERON, 1989, éditions Lavoisier.

Le transformateur est généralement un transformateur magnétique ; il peut être associé, à sa sortie, à un multiplicateur capacitif, ou à un double multiplicateur capacitif.

Une autre alimentation haute tension, décrite dans l'article « A TWT power supply for high phase stability transmitter », Sandro SANDRI, IEEE Proceedings, 1988 Eighteenth Power Modulator Symposium, Hilton Head, utilise le transformateur d'un flyback (hacheur inverseur isolé) pour réaliser la fonction élévation de tension. Dans cette alimentation, la tension issue du réseau électrique est redressée et filtrée de façon à obtenir une tension continue fixe, fournie en entrée du flyback. Celui-ci utilise alors une inductance couplée, appelée « transformateur du flyback », dont le rapport du nombre de spires fournit une élévation de tension. Les différents secondaires de cette inductance couplée sont mis en série afin d'additionner leurs tensions ; la régulation s'opère, comme pour un flyback classique, sur le rapport cyclique de l'interrupteur. La tension de sortie d'une telle alimentation est de 25 kV pour une puissance de 400 W.

D'autres sortes d'alimentations sont régulées sur la haute tension. La régulation se fait alors, après l'étage élévateur de tension et l'étage de redressement et de filtrage.

En fait, la régulation est effectuée sur la haute tension dans le cas où l'on souhaite obtenir une très faible ondulation de la tension de sortie et une régulation rapide. Il faut noter que dans de nombreux cas, une prérégulation est possible sur la basse tension de l'alimentation. C'est le cas, notamment, lorsque la régulation haute tension est réalisée au moyen des régulateurs linéaires. Dans le cas d'une prérégulation, on peut utiliser les différents types d'alimentations présentées précédemment, c'est-à-dire les alimentations régulées sur la basse tension.

D'une façon générale, la régulation sur la haute tension nécessite des composants haute tension et souvent une haute puissance. Pour la réalisation d'une alimentation régulée sur la haute tension, on peut utiliser un régulateur linéaire sur la haute tension. Celui-ci est souvent réalisé au moyen de tétrodes, c'est-à-dire de tubes à vides permettant une régulation précise, comme cela est décrit dans « Analysis and control of a 130 kV pulsed tetrode regulator », C. R. ROSE, J. C. CRON, Seventh IEEE Pulsed Power Conference, Monterey, 1989 et dans « A 1 MW (CW) modulator-regulator system for gyroklystrons », Raymond C. BLACK, John KLOUZEK, IEEE Proceedings, 1984 Sixteenth Power Modulator Symposium.

D'une façon générale, les régulateurs linéaires, de par leur principe de fonctionnement, ont des rendements généralement médiocres. Par ailleurs, les régulateurs linéaires, utilisés en haute tension, à savoir les tétrodes, ont une durée de vie relativement limitée. Ils présentent, de plus, un coût élevé.

La régulation sur la haute tension peut également être réalisée au moyen d'une alimentation à découpage de type hacheur à modulation de largeur d'impulsion. Par rapport au régulateur linéaire, les alimentations à découpage ont l'avantage de présenter une bonne fiabilité et un rendement plus élevé. Par contre, ces alimentations nécessitent un (ou plusieurs) interrupteur(s) haute tension rapide(s). Les articles « La mise en série des transistors de puissance, présentation d'un hacheur 200 kW - 4 kV », de J. M. ANDREJAK, J. P. ARCHES et P. C. CABALEIRO, Electronique de puissance n° 10 et « High voltage converters promising technological developments », J. M. ANDREJAK, M. LESCURE, Proceedings of EPE 87 Grenoble, présentent un hacheur réalisé au moyen d'une mise en série de transistors bipolaires de puissance. Ce hacheur fonctionne à 4 kV en sortie pour une puissance de 200 kW. Cependant, un tel hacheur est difficile à mettre en oeuvre pour une haute tension.

EP-A-353406 montre un interrupteur à haute tension réalisé par la mise en série de MOSFETs.

Les systèmes de régulation sous basse tension sont amenés, pour traiter de fortes puissances, à gérer des courants importants, ce qui implique généralement de réaliser un interrupteur fort courant par une mise en parallèle de semiconducteurs, si la capacité en courant des différents semiconducteurs est insuffisante. Il se pose alors un problème au niveau de la fiabilité de ce dispositif car la destruction de l'un des composants en parallèle implique la mise en court-circuit de l'ensemble des semiconducteurs et donc la défaillance de l'alimentation.

Un autre problème est celui de la valeur du filtre capacitif de sortie. En effet, en cas de défaut sur un équipement alimenté en haute tension, par exemple en cas de court-circuit, l'énergie contenue dans le filtre de sortie se dissipe dans l'équipement, qui peut alors être endommagé ; la dégradation est d'autant plus importante que l'énergie stockée est grande. Aussi, il est nécessaire de limiter l'énergie contenue dans le filtre en diminuant la valeur de la capacité de filtrage. Par contre, l'efficacité du filtre, c'est-à-dire sa capacité à atténuer les ondulations de tension, augmente avec la valeur du condensateur de filtrage et avec la fréquence de découpage du système de régulation, sauf, bien sûr, dans le cas du régulateur linéaire. Ainsi, pour diminuer la valeur d'un filtre, tout en conservant son efficacité, il est nécessaire de réaliser un système de régulation à fréquence de découpage élevée. Toutefois, pour des fréquences supérieures à 10 kHz, ce problème est nettement réduit.

La réalisation d'une alimentation à découpage fonctionnant à une fréquence supérieure à 10 kH et sous haute tension a donc été envisagée. Cette alimentation à découpage consiste, en fait, en un convertisseur DC/DC (c'est-à-dire un hacheur) alimenté sous haute tension et comportant un interrupteur K. La capacité $C_p$ représente les capacités parasites du montage.

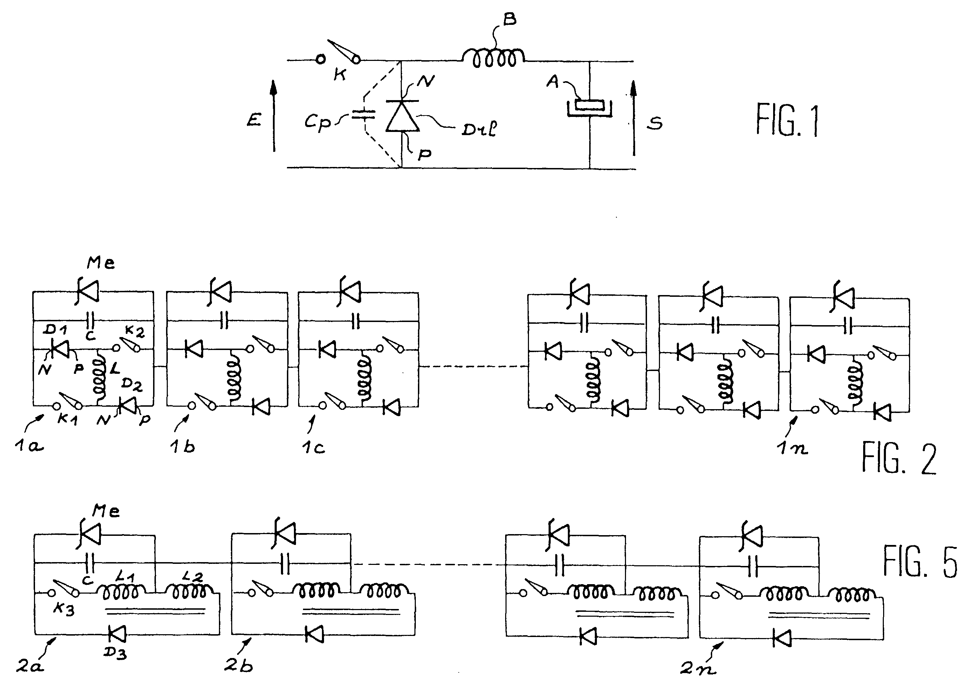

Sur la figure 1, on a représenté un tel convertisseur DC/DC. Il s'agit d'un hacheur-abaisseur. Ce convertisseur comporte une diode de roue libre $D_{RL}$ connectée par sa borne N à une inductance B et par sa borne P à une capacité A, elle-même connectée à l'inductance B. Un interrupteur K est connecté entre la borne N de la diode $D_{RL}$ et l'inductance B. La capacité $C_p$ représente les capacités parasites du montage.

Ce convertisseur DC/DC est alimenté par une tension continue d'entrée E et délivre une tension continue de sortie S, qui est inférieure à la tension E. L'interrupteur K est réalisé, comme expliqué précédemment, par une pluralité de semiconducteurs connectés en série. Cependant, une telle structure fonctionne en commutation dure, c'est-à-dire que les commutations de l'interrupteur K s'opèrent avec une présence simultanée de courant et de tension, ce qui provoque des pertes de commutation.

Un tel convertisseur DC/DC à haute tension pose un problème du point de vue des capacités parasites du macro-interrupteur K avec l'environnement. En effet, dans l'exemple de la figure 1, au moment de l'amorçage de l'interrupteur K, les capacités parasites $C_p$ se chargent, ce qui provoque un fort courant impulsionnel. Autrement dit, lorsque les semiconducteurs se ferment, la diode de roue libre se bloque et les capacités parasites $C_p$ se chargent, provoquant des courants parasites élevés. Ces derniers provoquent à leur tour une dissipation importante au niveau des semiconducteurs. L'énergie contenue dans ces capacités parasites peut être importante si la tension est très élevée, ce qui peut amener la détérioration des semiconducteurs.

Exposé de l'invention

L'invention a justement pour but de remédier aux inconvénients des convertisseurs DC/DC, décrits précédemment. A cette fin, elle propose un interrupteur électronique haute tension destiné à remplacer l'interrupteur K du convertisseur décrit ci-dessus. Cet interrupteur est réalisé à partir d'une pluralité de cellules de commutation résonantes connectées en série. Chacune de ces cellules est constituée d'un ou de plusieurs interrupteurs commandables à la fermeture et à l'ouverture, d'une ou plusieurs diodes, d'une ou plusieurs inductances, d'un condensateur de résonance et d'un moyen d'écrêtage.

De façon plus précise, l'invention concerne un interrupteur électronique haute tension traversé par un courant principal et comportant au moins deux cellules résonantes connectées en série. Chaque cellule résonante de cet interrupteur comporte :

- au moins une diode de bornes N et P ;
- au moins une inductance ;
- au moins un condensateur de résonance ;
- au moins un moyen écrêteur de tension ; et
- au moins un moyen d'interruption du courant dans la cellule, tel que la fermeture de ce moyen d'interruption provoque une décharge du condensateur de résonance dans l'inductance de sorte que le courant principal traverse chaque cellule et l'ouverture de ce moyen d'interruption provoque le chargement du condensateur de résonance à partir de l'inductance par l'intermédiaire de la diode, ledit condensateur ayant une tension à ses bornes de même polarité quel que soit l'état du moyen d'interruption et l'inductance étant traversée par un courant de même polarité quel que soit l'état dudit moyen d'interruption.

Selon un mode de réalisation de l'invention, chaque cellule comporte un premier et un second moyens d'interruption et une première et une seconde diodes, le premier moyen d'interruption étant connecté sur la borne P de la première diode, le second moyen d'interruption étant connecté sur la borne N de la seconde diode et l'inductance de la cellule étant connectée entre la borne P de la première diode et la borne N de la seconde diode, cet ensemble moyens d'interruption-diodes-inductance formant un circuit inducteur connecté en parallèle avec le condensateur de résonance, lui-même en parallèle avec le moyen écrêteur.

Selon un autre mode de réalisation de cet interrupteur, chaque cellule comporte une première et une seconde inductances connectées en série et couplées magnétiquement, la première inductance étant connectée, par ailleurs, au moyen d'interruption et la seconde inductance à la diode, cet ensemble moyen d'interruption-diode-inductances formant un circuit inducteur connecté, d'une part, par une borne entre les deux inductances et, d'autre part, par le moyen d'interruption, au condensateur de résonance, lui-même connecté en parallèle avec le moyen écrêteur.

Selon encore un autre mode de réalisation de cet interrupteur, chaque cellule comporte :

- un premier et un second moyens d'interruption ;
- une première et une seconde diodes, le premier moyen d'interruption étant connecté sur la borne P de la seconde diode et le second moyen d'interruption étant connecté sur la borne N de la première diode ;
- un premier ou un second moyens écrêteurs de tension connectés, respectivement, en parallèle entre l'entrée du premier moyen d'interruption et la borne N de la seconde diode, ou en parallèle sur le condensateur ;
- le condensateur de résonance étant connecté entre la borne P de la seconde diode et la borne N de la première diode et l'inductance étant connectée entre l'entrée de la cellule et la borne P de la première diode.

Avantageusement, la ou les inductances de chaque cellule sont couplées magnétiquement avec les inductances des autres cellules.

L'invention concerne, en outre, un convertisseur DC/DC haute tension comportant une diode de roue libre, une inductance, au moins une capacité de filtrage, et un interrupteur haute tension, tel que décrit ci-dessus.

Brève description des figures

- La figure 1, déjà décrite, représente un convertisseur DC/DC classique ;
- la figure 2 représente schématiquement un mode de réalisation d'un interrupteur utilisé dans le convertisseur DC/DC de la figure 1 ;
- la figure 3 représente, de façon schématisée, une cellule résonante de l'interrupteur de la figure 2 dans une structure de hacheur ;
- les figures 4A à 4F représentent schématiquement les différentes phases de fonctionnement de la cellule résonante de la figure 3 ;
- la figure 5 représente un second mode de réalisation de l'interrupteur K du convertisseur DC/DC de la figure 1 ;
- la figure 6 représente schématiquement une cellule résonante constituant l'interrupteur de la figure 5 ;
- les figures 7A à 7F représentent schématiquement les différentes phases de fonctionnement de la cellule résonante de la figure 6 ;
- la figure 8 représente, schématiquement, l'interrupteur de l'invention ;
- la figure 9 représente, schématiquement, une cellule résonante de l'interrupteur de la figure 2 dans une structure de hacheur ; et
- les figures 10A à 10F représentent, schématiquement, les différentes phases de fonctionnement de la cellule résonante de la figure 3.

Exposé de modes de réalisation de l'invention

Sur la figure 2, on a représenté le schéma de câblage d'un interrupteur K destiné à être utilisé dans le convertisseur DC/DC, montré sur la figure 1. Cet interrupteur K, comporte une pluralité de cellules résonantes, appelées aussi « cellules de commutation », associées en série les unes avec les autres.

Comme on le voit sur la figure 1, l'interrupteur haute tension K comporte n cellules de résonance, référencées 1a, 1b,..., 1n. Chacune de ces cellules de résonance comporte deux interrupteurs K1 et K2, deux diodes D1 et D2, une inductance L, un condensateur de résonance C et un moyen écrêteur $M_e$.

Ces différents éléments ont été représentés dans chacune des cellules de résonance de la figure 2, mais ils ne sont référencés que dans la cellule de résonance 1a. Les autres cellules 1b, 1c,..., 1n de cet interrupteur K ne seront pas décrites car elles sont toutes identiques à la cellule 1a. D'après cette cellule 1a, la diode D1 est connectée, par sa borne P, au moyen d'interruption K2 (appelé aussi interrupteur) et la diode D2 est connectée, par sa borne N, à l'interrupteur K1 (appelé aussi moyen d'interruption). Une inductance L est connectée entre la borne P de la diode D1 et la borne N de la diode D2. Cet ensemble D1, D2, K1, K2 et L forme ce que l'on appellera, par la suite, « le circuit inducteur ».

Un condensateur de résonance C est connecté en parallèle sur ce circuit inducteur ; un moyen écrêteur $M_e$ est connecté également en parallèle sur le condensateur de résonance.

Ce moyen écrêteur $M_e$ a pour rôle de limiter la tension maximale aux bornes du condensateur C et de protéger en tension les interrupteurs K1 et K2 et les diodes D1 et D2.

Une de ces cellules de résonance est représentée sur la figure 3 et montre le fonctionnement de cette cellule dans une structure de hacheur-abaisseur.

On retrouve sur cette figure 3 le circuit inducteur, réalisé par les diodes D1, D2, les interrupteurs K1 et K2 et l'inductance L, avec, en parallèle sur ce circuit inducteur, le condensateur de résonance C. Le moyen écrêteur $M_e$ n'a pas été représenté car il n'influe pas sur le fonctionnement général des cellules de résonance.

Pour expliquer le fonctionnement de cette cellule, on suppose que le courant de sortie du hacheur est constant et égal à $I_0$. On suppose également que la tension d'entrée du hacheur est constante et égale à E. Cette cellule de résonance reçoit donc en entrée une tension E et fournit en sortie un courant $I_0$, schématisé sur la figure 3 par une source de courant. En parallèle, sur cette source de courant, est connectée une diode de roue libre $D_{RL}$.

La fermeture des interrupteurs K1 et K2 provoque une décharge résonante dans le condensateur de résonance C qui cède alors son énergie à l'inductance de résonance L. Le courant principal de l'interrupteur K traverse alors les interrupteurs K1 et K2 et l'inductance de résonance L de chaque cellule de résonance de l'interrupteur K.

L'ouverture des interrupteurs K1 et K2 de chaque cellule de résonance provoque le renvoi de l'énergie de l'inductance de résonance L vers le condensateur de résonance C par l'intermédiaire des diodes D1 et D2.

Il est à noter que la tension aux bornes du condensateur C a la même polarité qu'à l'origine, c'est-à-dire qu'elle a la même polarité quel que soit l'état des interrupteurs K1 et K2 ; la tension aux bornes du condensateur C ne s'inverse pas.

Il est à noter aussi que le courant traversant l'inductance de résonance L a toujours la même polarité dans toutes les phases de fonctionnement de l'interrupteur électronique K.

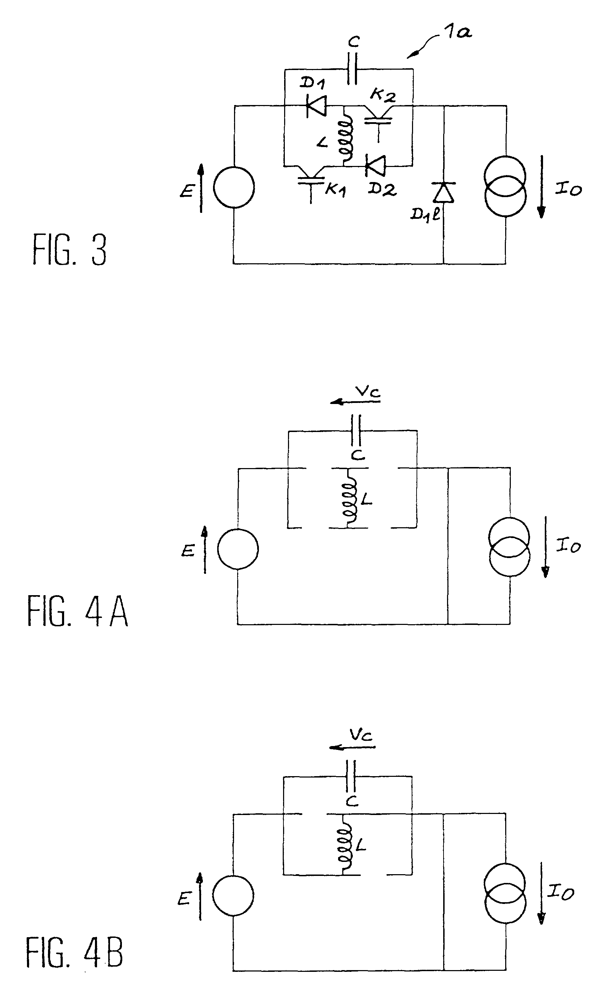

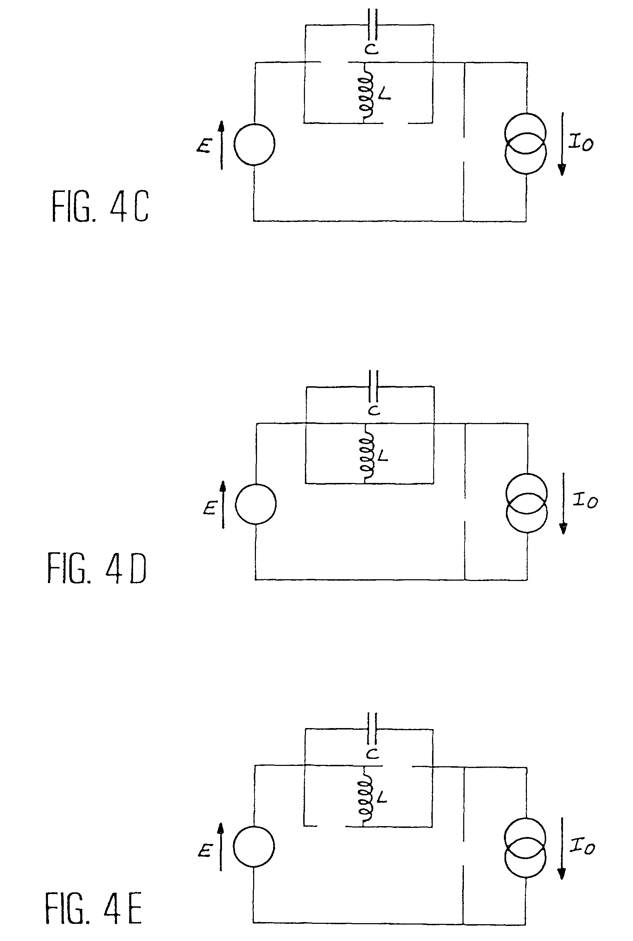

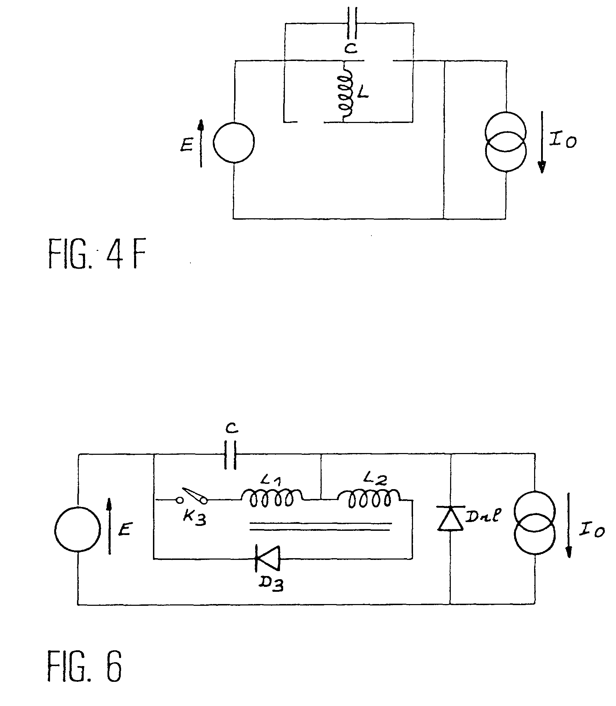

Les figures 4A à 4F montrent les différentes phases de fonctionnement du circuit hacheur-abaisseur, de la figure 3.

La figure 4A représente la phase initiale du fonctionnement, appelée phase de roue libre. Dans cette phase, qui est la phase initiale du fonctionnement, les interrupteurs K1 et K2 sont ouverts, et les diodes D1 et D2 sont bloquées, tandis que la diode de roue libre $D_{RL}$ est conductrice. C'est une phase stable. Le courant aux bornes de l'inductance est nul.

Sur la figure 4B, on a représenté la seconde phase du fonctionnement du circuit hacheur-abaisseur de la figure 3. Dans cette phase, on ferme les interrupteurs K1 et K2. L'inductance L est alors soumise à la tension E. La capacité C reste chargée à E. Le courant dans la diode de roue libre $D_{RL}$ s'annule au bout d'un temps t = L x $I_0$/E, ce qui provoque, à cet instant, l'ouverture de la diode de roue libre.

Sur la figure 4C, on a représentée la troisième phase du fonctionnement du circuit de la figure 3. Lorsque la diode de roue libre $D_{RL}$ se bloque, l'inductance L et la capacité C entrent en résonance. Le courant dans l'inductance augmente, tandis que la capacité se décharge. Ainsi, lorsque la tension $V_C$ aux bornes du condensateur de résonance C s'annule, les diodes D1 et D2 entrent en conduction.

Sur la figure 4D, on a représenté la quatrième phase du circuit hacheur-abaisseur. Dans cette phase, les interrupteurs K1 et K2 et les diodes D1 et D2 sont conducteurs. Le courant contenu dans l'inductance L circule en roue libre au travers de K1/D1 et K2/D2. Le courant $I_0$ passe au travers de D1/K2 et K1/D2. La capacité C est court-circuitée. Cette phase est stable et n'évolue qu'à l'ouverture des interrupteurs K1 et K2.

Sur la figure 4E, on a représenté la quatrième phase de fonctionnement du circuit hacheur-abaisseur. Au cours de cette phase, lorsque l'on ouvre simultanément les interrupteurs K1 et K2, une résonance se produit entre l'inductance L et la capacité C. La capacité C se charge, tandis que le courant dans l'inductance L diminue. Lorsque la tension aux bornes du condensateur C est égale à E, alors la diode de roue libre s'amorce.

Sur la figure 4F, on a représenté la sixième phase du fonctionnement du circuit hacheur-abaisseur. Lorsque la diode de roue libre s'amorce, la capacité C reste chargée à la tension E, tandis que le courant dans l'inductance L diminue linéairement. Lorsque le courant dans l'inductance s'annule, les diodes D1 et D2 se bloquent et l'on revient à la phase initiale de roue libre, représentée sur la figure 4A.

Sur la figure 5, on a représenté un autre mode de réalisation de l'interrupteur électronique haute tension K destiné à être utilisé dans le convertisseur DC/DC. Cet interrupteur K comporte, comme dans le premier mode de réalisation, une pluralité de cellules résonantes (ou cellules de commutation) connectées en série et référencées 2a, 2b,..., 2n.

Toutes ces cellules de résonance 2a, 2b,..., 2n sont identiques ; seule la cellule 2a sera décrites.

Chacune de ces cellules de résonance comporte un circuit inducteur constitué de deux inductances L1 et L2 connectées en série et couplées magnétiquement. Le circuit inducteur comporte, de plus, un interrupteur K3 (appelé aussi moyen d'interruption), connecté en entrée de l'inductance L1, et une diode D3 connectée en sortie de l'inductance L2.

Un condensateur de résonance C est connecté en parallèle sur l'interrupteur K3 et l'inductance L1 ;

il est lui-même connecté en parallèle avec un moyen écrêteur $M_e$.

On a représenté sur la figure 6, le schéma de fonctionnement de la cellule 2a, dans la structure de hacheur-abaisseur décrite précédemment.

Pour ce fonctionnement, on suppose que le courant de sortie $I_0$ est constant. On suppose également que la tension d'entrée E est constante.

Dans ces conditions, on obtient sur la figure 6, le schéma électrique suivant, dans lequel la cellule 2a reçoit en entrée une tension E et émet en sortie un courant $I_0$, représenté par la source de tension. Tout comme dans le mode de réalisation précédent, une diode de roue libre $D_{RL}$ est connectée en parallèle sur la source de courant.

On voit sur ce schéma que les moyens écrêteurs $M_e$ n'ont pas été représentés, car ils ne modifient pas le fonctionnement global de la cellule résonante.

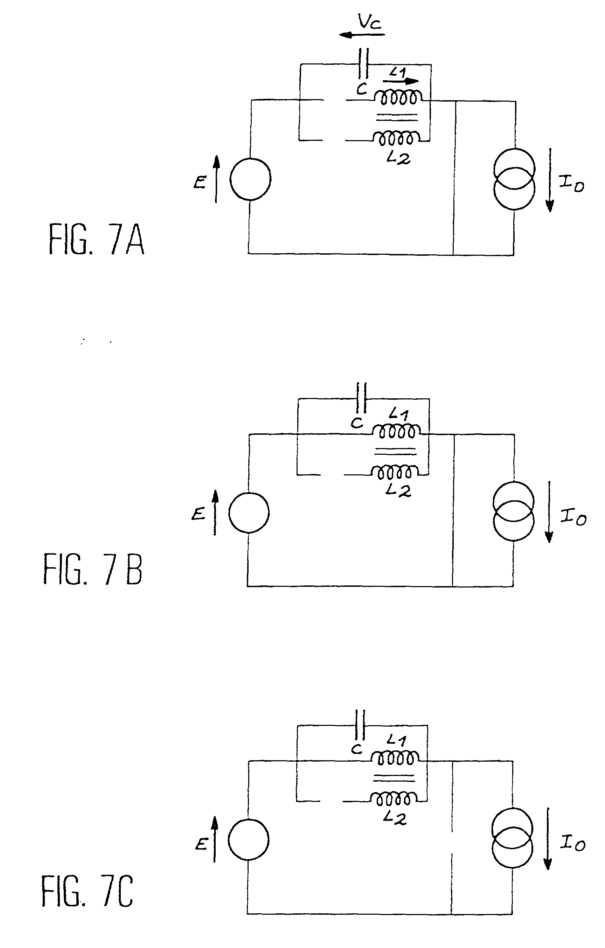

Sur les figures 7A à 7F, on a représenté les six différentes phases de fonctionnement du circuit de la figure 6.

Sur la figure 7A, on a schématisé la phase initiale, c'est-à-dire la phase de roue libre. Dans cette phase, l'interrupteur K3 et la diode D3 sont bloqués, tandis que la diode de roue libre $D_{RL}$ conduit. C'est une phase stable ; K3 et D3 supportent chacun une tension E.

Sur la figure 7B, on a schématisé la seconde phase de fonctionnement du circuit hacheur abaisseur de la figure 6. Dans cette phase, on ferme l'interrupteur K3. Les inductances L1 et L2 sont alors soumises à la tension E. La capacité de résonance C reste chargée à E. Le secondaire des inductances impose une tension - E qui maintient la diode D3 bloquée. Cette diode D3 supporte alors une tension de 2E. Le courant dans la diode de roue libre s'annule au bout d'un temps t, qui est égal à L x $I_0$/E, ce qui provoque, à cet instant, l'ouverture de la diode de roue libre $D_{RL}$.

Sur la figure 7C, on a représenté la troisième phase de fonctionnement du circuit hacheur-abaisseur de la figure 6. Lorsque la diode de roue libre se bloque, les inductances L1 et L2 et la capacité C entrent en résonance. Le courant dans les inductances augmente, tandis que la capacité C se décharge. Lorsque la tension $V_C$ aux bornes de la capacité C devient nulle, alors la diode D3 entre en conduction.

Sur la figure 7D, on a représenté la quatrième phase de fonctionnement du circuit hacheur-abaisseur. Au cours de cette phase, on considère que l'interrupteur K3 et la diode D3 sont conducteurs. Le courant continu dans les inductances $L_1$ et $L_2$, circule en roue libre au travers de l'interrupteur K3 et de la diode D3. Le courant $I_0$ passe au travers de cet interrupteur et de cette diode. La capacité C est court-circuitée et on a, par conséquent, une tension $V_C$ nulle. Cette phase est stable et n'évolue qu'à l'ouverture des interrupteurs.

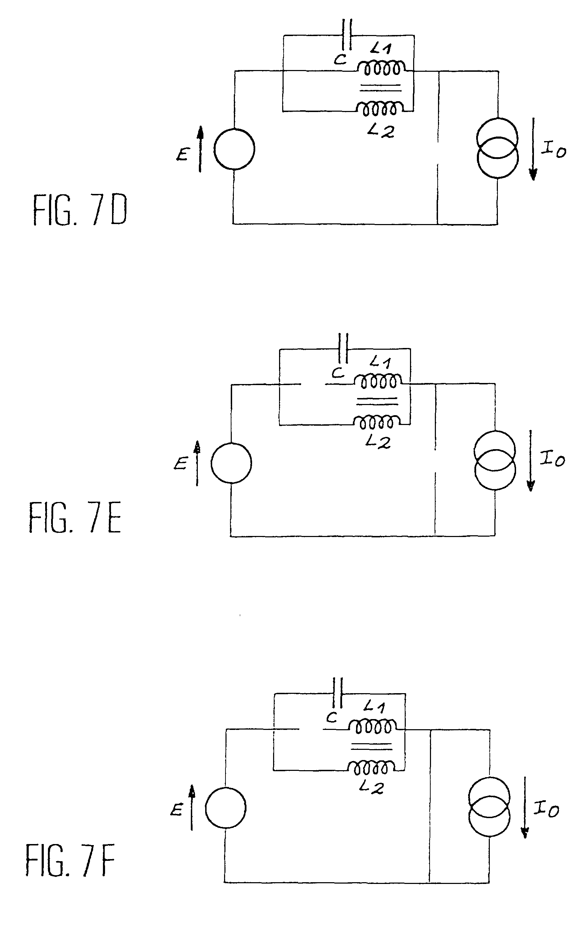

Sur la figure 7E, on a représenté la cinquième phase du fonctionnement du circuit. Lorsque l'interrupteur K3 est ouvert, une résonance se produit entre les

inductances $L_1$ et $L_2$ et la capacité C. Cette capacité C se charge, tandis que le courant dans les inductances diminue. Ainsi, lorsque $V_C$ = E, la diode de roue libre s'amorce.

Sur la figure 7F, on a représenté la sixième phase de fonctionnement du circuit hacheur-abaisseur de la figure 6. Lorsque la diode de roue libre s'amorce, la capacité C reste chargée à la tension E, tandis que le courant dans l'inductance diminue linéairement ; l'interrupteur K3 supporte une tension de 2E. Lorsque le courant dans l'inductance s'annule, la diode D3 se bloque et on revient alors à la phase initiale de roue libre.

Quel que soit le mode de réalisation de l'interrupteur électronique K (mode de réalisation de la figure 2 ou de la figure 5), la ou les inductance(s) de chacune des cellules peuvent être couplées avec les inductances des autres cellules, ce qui permet d'équilibrer les tensions des cellules.

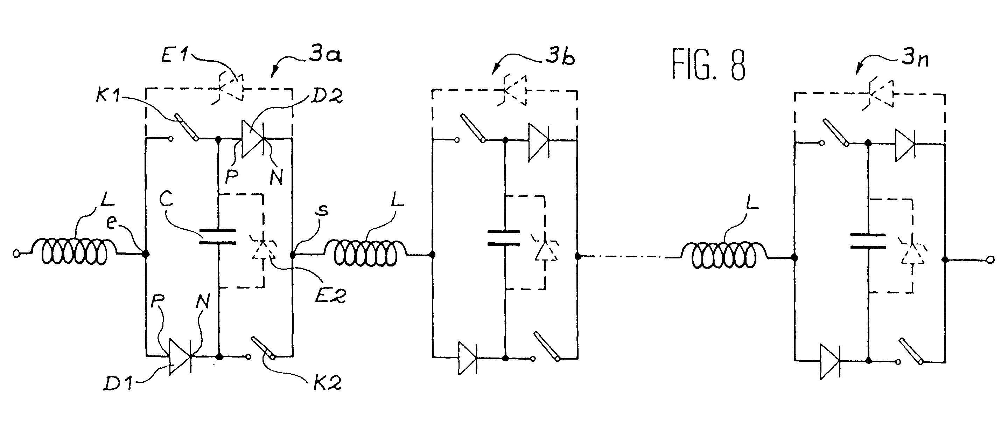

Sur la figure 8, on a représenté le schéma de câblage d'un interrupteur K destiné à être utilisé dans le convertisseur DC/DC, montré sur la figure 1. Cet interrupteur K, comporte une pluralité de cellules résonantes, appelées aussi « cellules de commutation », associées en série les unes avec les autres.

Comme montré sur la figure 8, l'interrupteur haute tension K comporte n cellules de résonance, référencées 3a, 3b,..., 3n. Chacune de ces cellules de résonance comporte deux interrupteurs K1 et K2, deux diodes D1 et D2, une inductance L, un condensateur de résonance C et deux moyens écrêteurs E1 et E2.

Ces différents éléments ont été représentés dans chacune des cellules de résonance de la figure 8, mais ils ne sont référencés que dans la cellule de résonance 3a, les cellules 3b,..., 3n étant identiques à cette cellule 3a.

Dans chaque cellule, le premier interrupteur K1 (ou moyen d'interruption) est connecté à la borne P de la seconde diode D2 ; parallèlement, la première diode D1 est connectée par sa borne N au second interrupteur K2. Le condensateur C est connecté entre la borne P de la diode D2 et la borne N de la diode D1.

Un premier moyen écrêteur E1 est connecté en parallèle sur l'ensemble constitué de l'interrupteur K1 et de la diode D2 de façon à protéger cet ensemble, en tension.

Un autre moyen de réaliser cette fonction est d'utiliser un moyen écrêteur E2 connecté en parallèle sur le condensateur C de façon à limiter la tension maximale aux bornes de ce dernier.

Une inductance L est connectée entre l'entrée de la cellule et la borne P de la diode D1, c'est-à-dire sur la borne d'entrée e de l'ensemble constitué des diodes D1, D2, des interrupteurs K1, K2, des moyens écrêteurs E1, E2 et du condensateur C.

Une borne de sortie s située, symétriquement à la borne d'entrée e, entre la borne N de la diode D2 et la sortie de l'interrupteur K2, assure la connexion avec la cellule résonante suivante.

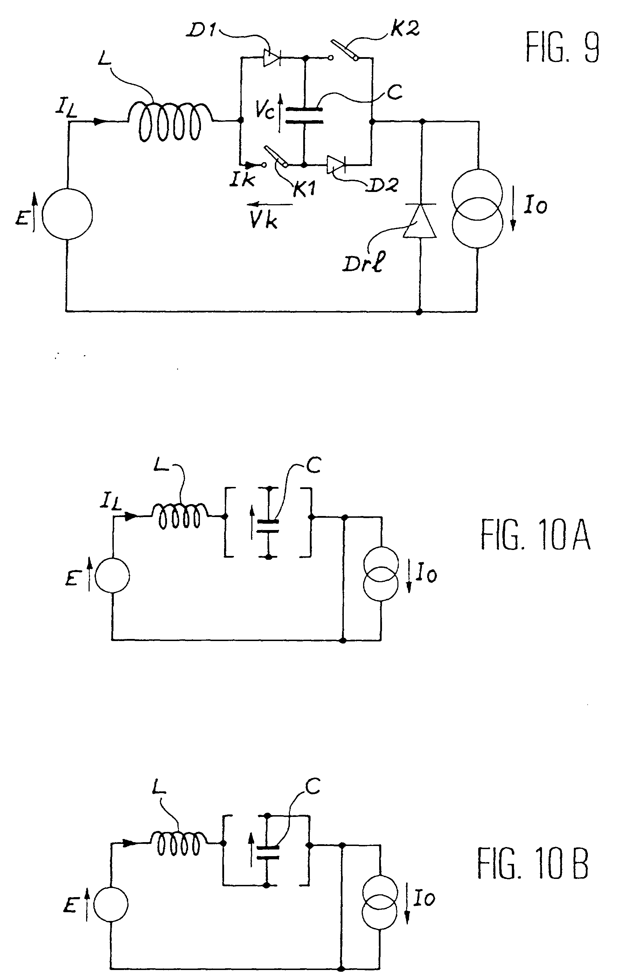

Une de ces cellules de résonance est représentée sur la figure 9 et montre le fonctionnement de cette cellule dans une structure de hacheur-abaisseur.

On retrouve, sur cette figure 9, les composants de la cellule 3a de la figure 8, exceptés les moyens écrêteurs E1 et E2 qui n'ont aucune influence sur le fonctionnement général des cellules de résonance. Leur rôle est uniquement d'assurer une certaine limitation des tensions dans les cellules.

Pour expliquer le fonctionnement de cette cellule, on suppose que le courant de sortie du hacheur est constant et égal à $I_0$. On suppose également que la tension d'entrée du hacheur est constante et égale à E. Cette cellule de résonance reçoit donc en entrée une tension E et fournit en sortie un courant $I_o$, schématisé sur la figure 9 par une source de courant. En parallèle sur cette source de courant, est connectée une diode de roue libre $D_{rl}$.

La fermeture des interrupteurs K1 et K2 provoque une décharge résonante dans le condensateur de résonance C qui cède alors son énergie à l'inductance de résonance L. Le courant principal de l'interrupteur K traverse alors les interrupteurs K1 et K2 et l'inductance de résonance L de chaque cellule de résonance de l'interrupteur haute tension K.

L'ouverture des interrupteurs K1 et K2 de chaque cellule de résonance provoque le renvoi de l'énergie d'inductance de résonance L vers le condensateur de résonance C par l'intermédiaire des diodes D1 et D2.

Il est à noter que la tension aux bornes du condensateur C a la même polarité qu'à l'origine, c'est-à-dire qu'elle a la même polarité quel que soit l'état des interrupteurs K1 et K2 ; la tension aux bornes du condensateur C ne s'inverse pas.

Il est à noter aussi que le courant traversant l'inductance de résonance L a toujours la même polarité dans toutes les phases de fonctionnement de l'interrupteur haute tension K.

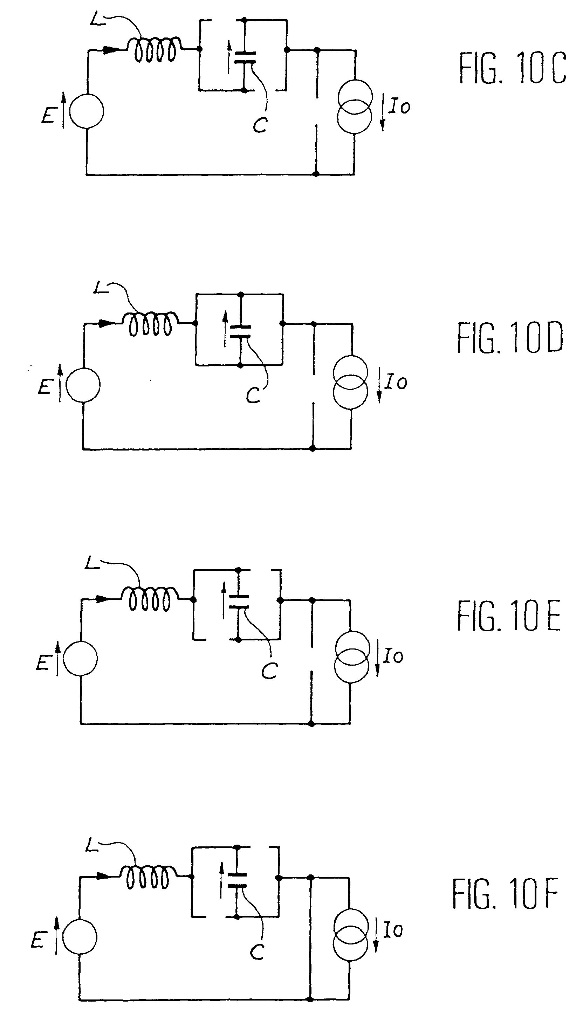

Les figures 10A à 10F montrent les différentes phases de fonctionnement du circuit hacheur-abaisseur, de la figure 9.

La figure 10A représente la phase initiale du fonctionnement, appelée phase de roue libre. Dans cette phase de fonctionnement, les interrupteurs K1 et K2 sont ouverts et les diodes D1 et D2 sont bloquées, tandis que la diode de roue libre $D_{rl}$ est conductrice. C'est une phase stable. K1/D1 et K2/D2 se partagent la tension $Vc = E + I_o \sqrt{L/C}$ .

Sur la figure 10B, on a représenté la seconde phase du fonctionnement du circuit hacheur-abaisseur de la figure 9. Dans cette phase, on ferme les interrupteurs K1 et K2. Il se produit une résonance entre l'inductance L et le condensateur C, dans laquelle le courant $I_L$ circulant dans l'inductance croît, tandis que le condensateur C se décharge. Le courant circulant dans la diode de roue libre $D_{rl}$ est $I_{Drl} = I_0 - I_L$.

Cette seconde phase se termine à l'instant où la diode de roue libre $D_{rl}$ se bloque, c'est-à-dire lorsque

$I_L = I_o$.

Sur la figure 10C, on a représenté la troisième phase de fonctionnement du circuit de la figure 3. Lorsque la diode de roue libre $D_{rl}$ se bloque, l'inductance L est traversée par le courant $I_0$, tandis que le condensateur C se décharge.

Cette phase se termine lorsque $V_C = 0$, provoquant la fermeture de D1 et D2.

Sur la figure 10D, on a représenté la quatrième phase du circuit hacheur-abaisseur. Dans cette phase, les interrupteurs K1 et D2 ainsi que les diodes D1 et D2 conduisent. Le courant $I_o$, qui traverse l'inductance L, se partage entre K1/D2 et K2/D1. La capacité C est court-circuitée ; on a donc $V_c = 0$. Cette phase est stable et n'évolue qu'à l'ouverture des interrupteurs.

Sur la figure 10E, on a représenté la cinquième phase de fonctionnement du circuit hacheur-abaisseur. Au cours de cette phase, lorsque l'on ouvre simultanément K1 et K2, le courant I0 vient charger le condensateur C. Lorsque $V_c = E$, la diode de roue libre $D_{rl}$ s'amorce.

Sur la figure 10F, on a représenté la sixième phase de fonctionnement du circuit hacheur-abaisseur. Lorsque la diode de roue libre $D_{rl}$ s'amorce, il se produit une résonance entre l'inductance L et le condensateur C. La tension $V_c$ augmente tandis que le courant $I_L$ dans l'inductance L diminue. Lorsque ce courant $I_L$ s'annule, les diodes D1 et D2 se bloquent et on revient à la phase de roue libre.

Un convertisseur DC/DC haute tension comportant un interrupteur haute tension tel que décrit précédemment voit sa durée de vie augmenter, par rapport aux dispositifs proposés dans l'art antérieur. De plus, les cellules de commutation formant l'interrupteur étant assemblées en série, l'interrupteur présente l'avantage de ne pas être totalement inopérant lorsqu'un composant d'une des cellules est défectueux.

En outre, dans les circuits décrits précédemment, la puissance est traitée par une haute tension ; ceci permet de gérer des courants réduits. Une réalisation sur circuit imprimé est donc possible, d'où une facilité de réalisation et une réduction des coûts par rapport à une structure fort courant, qui nécessite un montage mécanique souvent onéreux.

Par ailleurs, l'obtention de fréquences de découpage élevées, c'est-à-dire supérieures à 10 kHz, permet de réduire la valeur du filtre capacitif de sortie, tout en maintenant un filtrage efficace.

D'autre part, les capacités parasites avec l'environnement sont incluses dans les capacités des différents étages de l'interrupteur. Les courants parasites sont donc fortement réduits. De plus, l'énergie contenue dans les capacités parasites est recyclée dans l'énergie de résonance, au lieu d'être totalement dissipée dans les semi-conducteurs, comme c'est le cas dans les dispositifs de l'art antérieur.

**Revendications**

1. Interrupteur électronique haute tension traversé par un courant principal **caractérisé en ce qu'**il comporte au moins deux cellules de commutation (1a,..., 1n) connectées en série et assurant le recyclage des énergies des capacités parasites, chacune de ces cellules de commutation comportant :

   - au moins une diode (D1, D2) de bornes N et P ;
   - au moins une inductance (L) ;
   - au moins un condensateur de résonance (C) incluant les capacités parasités ;
   - au moins un moyen écrêteur de tension ($M_e$); et
   - au moins un moyen d'interruption (K1, K2) du courant dans la cellule, tel que la fermeture du moyen d'interruption provoque une décharge du condensateur de résonance et des capacités parasites dans l'inductance de sorte que le courant principal traverse chaque cellule et l'ouverture de ce moyen d'interruption provoque le chargement du condensateur de résonance et des capacités parasites à partir de l'inductance par l'intermédiaire de la diode, ledit condensateur ayant une tension à ses bornes de même polarité quel que soit l'état du moyen d'interruption et l'inductance étant traversée par un courant de même sens quel que soit l'état dudit moyen d'interruption.

2. Interrupteur selon la revendication 1, **caractérisé en ce que** chaque cellule (1a,..., 1n) comporte un premier et un second moyens d'interruption (K1, K2) et une première et une seconde diodes (D1, D2), le premier moyen d'interruption (K2) étant connecté sur la borne P de la première diode (D1), le second moyen d'interruption (K1) étant connecté sur la borne N de la seconde diode (D2) et l'inductance (L) de la cellule étant connectée entre la borne P de la première diode et la borne N de la seconde diode, cet ensemble moyens d'interruption-diodes-inductance formant un circuit inducteur connecté en parallèle avec le condensateur de résonance (C), lui-même en parallèle avec le moyen écrêteur ($M_e$).

3. Interrupteur selon la revendication 1, **caractérisé en ce que** chaque cellule (2a,..., 2n) comporte une première et une seconde inductances (L1, L2) connectées en série et couplées magnétiquement, la première inductance (L1) étant connectée, par ailleurs, au moyen d'interruption (K3) et la seconde inductance (L2) à la diode (D3), cet ensemble moyen d'interruption-diode-inductances formant un circuit inducteur connecté, d'une part, par une borne entre les deux inductances et, d'autre part, par le moyen d'interruption, au condensateur de résonance, lui-même connecté en parallèle avec le moyen écrêteur.

4.  Interrupteur selon la revendication 1, **caractérisé en ce que** chaque cellule comporte :

    -   un premier et un second moyens d'interruption (K1, K2)
    -   une première et une seconde diodes (D1, D2), le premier moyen d'interruption (K1) étant connecté sur la borne P de la seconde diode (D2) et le second moyen d'interruption (K2) étant connecté sur la borne N de la première diode (D1) ;
    -   un premier ou un second moyens écrêteurs de tension (E1, E2) connectés, respectivement, en parallèle entre l'entrée du premier moyen d'interruption et la borne N de la seconde diode, ou en parallèle sur le condensateur ;

    le condensateur de résonance (C) étant connecté entre la borne P de la seconde diode et la borne N de la première diode et l'inductance (L) étant connectée entre l'entrée de la cellule et la borne P de la première diode.

5.  Interrupteur selon l'une quelconque des revendications 1 à 4, **caractérisé en ce que** la ou les inductance(s) de chaque cellule sont couplées magnétiquement avec les inductances des autres cellules.

6.  Convertisseur DC/DC haute tension, comportant une diode de roue libre ($D_{RL}$), une inductance (B) et une capacité (A), **caractérisé en ce qu'**il comporte un interrupteur électronique haute tension selon l'une quelconque des revendications 1 à 5.

**Patentansprüche**

1.  Elektronischer Hochspannungsschalter, durchquert von einem Hauptstrom, **dadurch gekennzeichnet, dass** er wenigstens zwei Schaltzellen (1a, ..., 1n) umfasst, die in Serie geschaltet sind und die Rückführung der Energien der Streukapazitäten sicherstellen, wobei jede dieser Schaltzellen umfasst:

    -   wenigstens eine Diode (D1, D2) mit Anschlüssen N und P;
    -   wenigstens eine Induktivität (L),
    -   wenigstens einen die Streukapazitäten enthaltenden Resonanzkondenstator (C);
    -   wenigstens eine Spannungsspitzenwert-Begrenzungseinrichtung ($M_e$); und
    -   wenigstens eine Unterbrechungseinrichtung (K1, K2) des Stroms in der Zelle, derartig, dass das Schließen dieser Unterbrechungseinrichtung eine Entladung des Resonanz- und Streukapazitätenkondensators in die Induktivität bewirkt, so dass der Hauptstrom jede Zelle durchquert, und dass das öffnen dieser Unterbrechungseinrichtung das Laden des Resonanz- und Streukapazitätenkondensators aus der Induktivität bewirkt, über die Diode, wobei der genannte Kondensator unabhängig vom jeweiligen Zustand der Unterbrechungseinrichtungen an seinen Anschlüssen eine Spannung derselben Polarität aufweist und die Induktivität unabhängig vom jeweiligen Zustand der Unterbrechungseinrichtungen von einem Strom derselben Richtung durchquert wird.

2.  Schalter nach Anspruch 1, **dadurch gekennzeichnet, dass** jede Zelle (1., ..., 1n) eine erste und eine zweite Unterbrechungseinrichtung (K1, K2) und eine erste und eine zweite Diode (D1, D2) umfasst, wobei die erste Unterbrechungseinrichtung (K2) mit dem Anschluss P der ersten Diode (D1) verbunden ist, die zweite Unterbrechungseinrichtung (K1) mit dem Anschluss N der zweiten Diode (D2) verbunden ist, und die Induktivität (L) der Zelle zwischen dem Anschluss P der ersten Diode und dem Anschluss N der zweiten Diode angeschlossen ist, wobei dieses Unterbrechung-Dioden-Induktivitäts-System einen zu dem Resonanzkondensator (C) parallelgeschalteten Induktionskreis bildet, der seinerseits zu der Spitzenwertbegrenzungseinrichtung ($M_e$) parallelgeschaltet ist.

3.  Schalter nach Anspruch 1, **dadurch gekennzeichnet**, das jede Zelle (2a, ..., 2n) eine erste und eine zweite Induktivität (L1, L2) umfasst, in Serie geschaltet und magnetisch gekoppelt, wobei die erste Induktivität (L1) außerdem mit der Unterbrechungseinrichtung (K3) und die zweite Induktivität (L2) mit der Diode (D3) verbunden ist, und dieses einen Induktionskreis bildende Unterbrechung-Diode-Induktivitäten-System einerseits durch einen Anschluss zwischen den beiden Induktivitäten und andererseits durch die Unterbrechungseinrichtung mit dem Resonanzkondensator verbunden ist, der seinerseits zu der Spitzenwertbegrenzungseinrichtung parallelgeschaltet ist.

4.  Schalter nach Anspruch 1, **dadurch gekennzeichnet, dass** jede Zelle umfasst:

    -   eine erste und eine zweite Unterbrechungseinrichtung (K1, K2);
    -   eine erste und eine zweite Diode (D1, D2), wobei die erste Unterbrechungseinrichtung (K1)
    -   mit dem Anschluss der zweiten Diode (D2) verbunden ist, und die zweite Unterbrechungseinrichtung (K2) mit dem Anschluss N der ersten Diode (D1) verbunden ist;
    -   eine erste oder eine zweite Spannungsspitzenwert-Begrenzungseinrichtung (E1, E2), jeweils parallelgeschaltet zwischen dem Eingang der ersten Unterbrechungseinrichtung und dem Anschluss N der zweiten Diode oder parallelgeschaltet zum Kondensator;

wobei der Resonanzkondensator (C) zwischen dem Anschluss P der zweiten Diode und dem Anschluss N der ersten Diode angeschlossen ist, und die Induktivität (L) zwischen dem Eingang der Zelle und dem Anschluss P der ersten Diode angeschlossen ist.

5. Schalter nach einem der Ansprüche 1 bis 4, **dadurch gekennzeichnet, dass** die Induktivität(en) jeder Zelle magnetisch mit den Induktivitäten der anderen Zellen gekoppelt ist (sind).

6. Gleichstrom/Hochspannungsgleichstrom-Umspanner, eine Freilaufdiode (D$_{RL}$), eine Induktivität (B) und eine Kapazität (A) umfassend, **dadurch gekennzeichnet, dass** er einen elektronischen Hochspannungsschalter nach einem der Ansprüche 1 bis 5 umfasst.

**Claims**

1. High-voltage electronic make/break switch traversed by a main current **characterized in that** it comprises at least two switching cells (1a,..., 1n) connected in series and providing for the recycling of the energies of the stray capacitances, each of these switching cells comprising:

    - at least one diode (D1, D2) with N and P terminals;
    - at least one inductor (L);
    - at least one resonance capacitor (C) incorporating the stray capacitances;
    - at least one voltage clipper means (M$_e$); and
    - at least one make/break means (K1, K2) for interrupting the current in the cell, such that the closure of the make/break means causes a discharge of the resonance capacitor and of the stray capacitances into the inductor so that the main current traverses each cell and the opening of this make/break means causes the charging of the resonance capacitor and of the stray capacitances from the inductor by way of the diode, the said capacitor having a voltage across its terminals of like polarity whatever the state of the make/break means and the inductor being traversed by a current of like direction whatever the state of the said make/break means.

2. Make/break switch according to Claim 1, **characterized in that** each cell (1a,..., 1n) comprises a first and a second make/break means (K1, K2) and a first and a second diode (D1, D2), the first make/break means (K2) being connected to the P terminal of the first diode (D1), the second make/break means (K1) being connected to the N terminal of the second diode (D2) and the inductor (L) of the cell being connected between the P terminal of the first diode and the N terminal of the second diode, this make/break means/diodes/inductor assembly forming an inductor circuit connected in parallel with the resonance capacitor (C), itself in parallel with the clipper means (M$_e$) .

3. Make/break switch according to Claim 1, **characterized in that** each cell (2a,..., 2n) comprises a first and a second inductor (L1, L2) connected in series and magnetically coupled, the first inductor (L1) being connected, moreover, to the make/break means (K3) and the second inductor (L2) to the diode (D3), this make/break means/diode/inductors assembly forming an inductor circuit connected, on the one hand, by a terminal between the two inductors and, on the other hand, by the make/break means, to the resonance capacitor, itself connected in parallel with the clipper means.

4. Make/break switch according to Claim 1, **characterized in that** each cell comprises:

    - a first and a second make/break means (K1, K2);
    - a first and a second diode (D1, D2), the first make/break means (K1) being connected to the P terminal of the second diode (D2) and the second make/break means (K2) being connected to the N terminal of the first diode (D1) ;
    - a first or a second voltage clipper means (E1, E2) connected, respectively, in parallel between the input of the first make/break means and the N terminal of the second diode, or in parallel with the capacitor; the resonance capacitor (C) being connected between the P terminal of the second diode and the N terminal of the first diode and the inductor (L) being connected between the input of the cell and the P terminal of the first diode.

5. Make/break switch according to any one of Claims 1 to 4, **characterized in that** the inductor or inductors of each cell are coupled magnetically with the inductors of the other cells.

6. High-voltage DC/DC converter, comprising a freewheel diode (D$_{RL}$), an inductor (B) and a capacitor (A), **characterized in that** it comprises a high-voltage electronic make/break switch according to any one of Claims 1 to 5.

FIG. 1

FIG. 2

FIG. 5

FIG. 3

FIG. 4 A

FIG. 4 B

FIG. 4 C

FIG. 4 D

FIG. 4 E

FIG. 4 F

FIG. 6

FIG. 7A

FIG. 7 B

FIG. 7C

FIG. 7D

FIG. 7E

FIG. 7F

FIG. 8

FIG. 9

FIG. 10 A

FIG. 10 B

FIG. 10 C

FIG. 10 D

FIG. 10 E

FIG. 10 F